# EUROPEAN PATENT SPECIFICATION

(11) **EP 3 591 718 B1**
(45) Date of publication and mention of the grant of the patent: **01.06.2022**
(21) Application number: 18182315.4
(22) Date of filing: 06.07.2018
(51) Int. Cl.: H01L 31/042, H01L 31/048, H02S 20/10

(54) **ASSEMBLY AND MOUNTING OF SOLAR CELLS**
ZUSAMMENBAU UND MONTAGE VON SOLARZELLEN
ENSEMBLE ET MONTAGE DE CELLULES SOLAIRES

(43) Date of publication of application: 08.01.2020
(60) Divisional application: 22169412.8
(73) Proprietor: SolAero Technologies Corp., Albuquerque, NM 87123 (US)
(72) Inventor: Wrosch, Matthew, Escondido, CA 92027 (US); Mcnaul, Eric, BOULDER, CO 80301 (US); Stern, Theodore, EL CAJON, CA 92020 (US); Hernandez, Fadel, LA MESA, CA 91942 (US)
(74) Representative: de Rooij, Mathieu Julien

(56) References cited:
- WO-A1-2013/187236
- US-A1- 2016 194 072
- US-A1- 2017 012 160
- US-A1- 2017 012 163

## Description

### Field of the Disclosure

The present disclosure relates to the field of airfoils, and photovoltaic solar arrays mounted on such airfoils, and more particularly to fabrication processes utilizing, for example, multijunction solar cells based on III-V semiconductor compounds mounted on a flexible film and adhered to the airfoil structure.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to manufacture. Typical commercial III-V compound semiconductor multijunction solar cells have energy efficiencies that exceed 27% under one sun, air mass 0 (AM0), illumination, whereas even the most efficient silicon technologies generally reach only about 18% efficiency under comparable conditions. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

Solar panels are generally formed by combining a large number of solar cells in an array. Individual solar cells, frequently with a rectangular or generally square-shape and sometimes with cropped corners, are connected in series to form a string of solar cells, whereby the number of solar cells used in the string determines the output voltage. Solar cells or strings of solar cells can also be interconnected in parallel, so as to increase the output current. In the field of aerospace applications, individual solar cells are provided with interconnects which are then combined to form an array. Conventionally, these large solar cells have been mounted on a support and interconnected using electrical interconnects. US 2017/0012163 discloses a method of manufacturing a solar cell array using a composite face sheet and double-sided adhesive. US 2016/0194072 discloses a method of manufacturing a solar cell array for an airfoil using an assembly fixture having a convex surface.

There is a continuing need for improved methods of manufacturing and assembling photovoltaic solar arrays that can result in decreases in cost and/or increases in performance.

Accordingly, the present disclosure provides improved methods of manufacturing and assembling photovoltaic solar arrays on a surface that requires a highly smooth surface to achieve laminar flow such as an airfoil for an aircraft wing or other surface that can result in decreases in cost, greater compactness, and increases performance.

### SUMMARY OF THE INVENTION

Objects of the Disclosure The invention refers to a method of fabricating a solar cell array as defined by the subject-matter of claim 1.

It is an object of the present disclosure to provide processes for producing solar cell panels for aerospace applications.

It is another object of the present disclosure to provide an assembly tool for producing solar cell panels for aerospace applications.

It is another object of the disclosure to provide methods for making a solar cell panel with an extremely smooth outer surface.

It is another object of the disclosure to provide for an assembly fixture and method that facilitates assembly of at least certain steps of the process for manufacture of solar cell assemblies on the fixture.

Some implementations of the present disclosure may incorporate or implement fewer of the aspects and features noted in the foregoing objects Features of the Disclosure

Briefly, and in general terms, the present disclosure provides a method of fabricating a solar cell panel in a process by applying an adhesive film to a fixture of support, positioning a solar cell assembly over the adhesive film, applying pressure to adhere the assembly to the support; and removing the assembly from the fixture.

Also disclosed, but not claimed is a method of fabricating an airfoil comprising: providing an assembly fixture having a smooth, concave surface; mounting a film composed of ethylene tetrafluoroethylene (ETFE) directly on the surface of the fixture; mounting a film composed of a non-crosslinked silicone pressure sensitive adhesive (PSA) directly over the ETFE film; mounting an array of interconnected solar cells, each having a top (or light-facing) side, and a back side, directly over the adhesive film; mounting an uncured supporting film composed of a composite material directly on the back side of the solar cell array adjacent the adhesive film; co-curing the film of composite material so that the array of interconnected solar cells is bonded to the supporting film; and removing the bonded and cured film of the composite material and an array of interconnected solar cells with the ETFE film from the assembly fixture.

In another embodiment, the present disclosure provides a method of fabricating a solar cell array carrier comprising: providing a carbon composite face sheet; providing a double sided adhesive film and positioning it on the top surface of the face sheet; bonding the bottom surface of the adhesive film to the top surface of the face sheet by co-curing; sequentially positioning a sequence of solar cell assemblies over the top surface of the adhesive film; and sequentially bonding each of the sequence of solar cell assemblies to a predefined region on the top surface of the face sheet.

In some embodiments, a plurality of solar cells are disposed closely adjacent to one another on each of the strips by a distance between 5 and 25 microns.

In some embodiments, each of the solar cells has a dimension in the range of 0.5 to 10 mm on a side.

In some embodiments of the disclosure, the back side support is polymide film layer such as KAPTON. KAPTON^{®} is a trademark of E.I. du Pont de Nemours and Company. The chemical name for KAPTON^{®} is poly (4, 4'-oxydiphenylene-pyromellitimide). Other polymide film sheets or layers may also be used.

In some embodiments, the solar cell array further comprises a foam supporting structure bonded to the support or film of the composite material.

In some embodiments, the array of interconnected solar cells are III-V compound semiconductor multijunction solar cells.

In some embodiments, the surface of the assembly fixture has a surface roughness of less than 0.001 inches (25.40 microns) rms .

In some embodiments, a portion of the assembly fixture is shaped such as to form an airfoil shaped surface.

A pressure-sensitive adhesive (PSA) is an adhesive which forms a bond between the adhesive and the adherend when pressure is applied. In some embodiments, the pressure sensitive adhesive is a single monomer or co-monomer silicone blend.

In some embodiments, a double-faced pressure-sensitive adhesive template or patch is positioned on the backside of the solar cell assembly. In some embodiments, the PSA may be a patterned layer, or it may be a continuous layer. For instance, the PSA may be patterned into the shape of solar cells.

In some embodiments, the double-faced pressure-sensitive adhesive template or patch and the polyimide film are bonded together without the use of a co-curing process.

In some embodiments, the double-faced pressure-sensitive adhesive template is covered at least partially with a release liner which is removed before making the bonding with the substrate.

In some embodiments, the PSA film may be an acrylic or a silicone adhesive, or any other suitable material.

In some embodiments, the PSA film may have one or two release liners, or possibly no release liners. In some embodiments, the PSA film may have continuous release liners that are removed in one step, or it may have a multiplicity of release liners that are removed individually.

In some embodiments, a rigid substrate may be used, such as an aluminum honeycomb substrate with carbon composite face sheet.

In some embodiments, the PSA film may also be applied to the back of the solar cells or solar cell assemblies.

In some embodiments, a pressure sensitive adhesive (PSA) film is prepared as a single layer.

In some embodiments, the PSA film may be prepared onto a permanent flexible substrate, such as a polyimide, with a release liner or liners on the opposite side.

In some embodiments, there may be a multiplicity of individual PSA patterns, each with its own front and back release liners. In some embodiments, there may be a multiplicity of individual PSA patterns, with one single, continuous release liner on one side and a multiplicity of release liners on the opposite side.

In some embodiments, there may be a multiplicity of individual PSA patterns with two continuous release layers covering the multiplicity of patterns on both sides. In some embodiments, there may be a single, continuous film of PSA with release liners on one or both sides.

In some embodiments, the PSA film is used to bond solar cells or solar cell assemblies to a substrate.

In some embodiments, the PSA film may be applied first to the substrate, and then the solar cells attached to the PSA film, or it may be applied first to the back of the solar cells, and then the solar cells with PSA film are applied to the substrate.

In some embodiments, if the PSA film is prepared on a permanent substrate, the solar cells or solar cell assemblies may be applied directly to the PSA film.

In some embodiments, the assembly of polyimide-PSA-release liner is bonded directly to a solar panel substrate by co-curing the polyimide film to the face of the solar panel substrate. The solar panel substrate to which the polyimide is bonded includes a composite face sheet, and it may have a carbon composite face sheet. It may be a rigid substrate, or it may be a flexible substrate.

In some embodiments, following the above described assembly, the substrate is ready to have the solar cells or solar cell assemblies bonded to it. The release liner is removed when it is time to bond the solar cells, which exposes the PSA, and the solar cells are bonded to the PSA and the substrate. Since the PSA thickness is precisely controlled during manufacturing, the bondline is uniform and there is less opportunity to entrap air than when a liquid adhesive is used.

In another non-claimed aspect, the present disclosure provides an aircraft or airfoil body and its method of fabrication comprising a solar array manufactured according to any of the examples disclosed herein.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teachings herein will recognize additional applications, modifications and embodiments in other fields, which are within the scope of the invention as claimed herein and with respect to which the disclosure could be of utility.

### BRIEF DESCRIPTION OF THE DRAWING

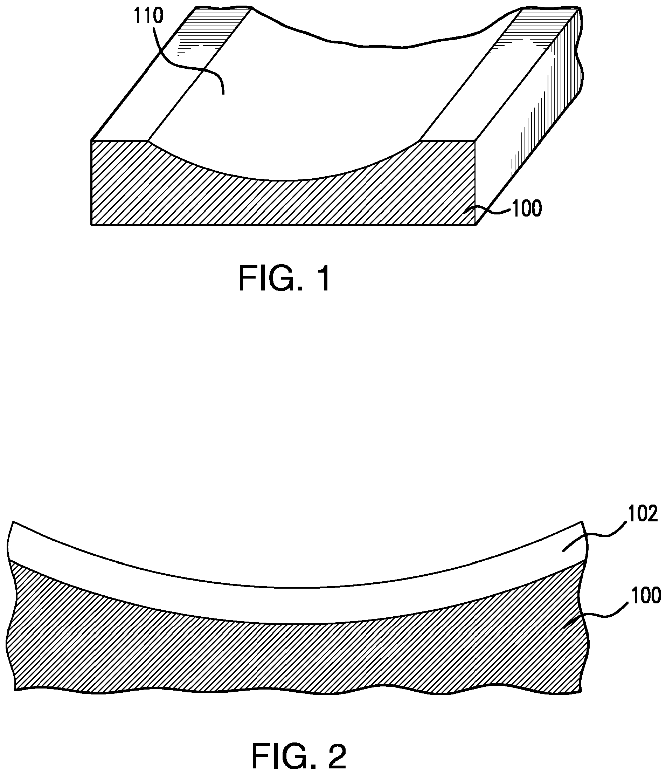

To complete the description and in order to provide for a better understanding of the disclosure, a set of drawings is provided. Said drawings form an integral part of the description and illustrate embodiments of the disclosure, which should not be interpreted as restricting the scope of the disclosure, but just as examples of how the disclosure can be carried out. The figures 1 - 8 and 12 illustrate examples which are not covered by the claims. These figures do therefore not refer to embodiments of the present invention, although the wording "embodiment" might be used in the description of these figures.

The drawings comprise the following figures:
FIG. 1 is a perspective view of a fixture for assembling the airfoil or solar cell assembly according to an example of the present disclosure;
FIG. 2 is a cross-sectional view of the surface of the fixture of FIG. 1;
FIG. 3 is a cross-sectional view of the assembly of FIG. 2 after the next process step according to this example;
FIG. 4 is a cross-sectional view of the assembly of FIG. 2 after the next process step according to this example;
FIG. 5 is a cross-sectional view of the assembly of FIG. 2 after the next process step according to this example;
FIG. 6 is a cross-sectional view of the assembly of FIG. 2 after the next process step according to this example;
FIG. 7 is a cross-sectional view of a solar cell assembly or airfoil structure as fabricated in FIG. 6 after removal from the fixture according to this example;
FIG. 8 is a perspective view of an airfoil of FIG. 7;
FIG. 9 is a perspective view of an exemplary embodiment of a watercraft having a solar assembly, according to the present disclosure, attached to a non-planar surface of the watercraft;
FIG. 10 is a perspective view of an exemplary embodiment of an aircraft having a solar assembly, according to the present disclosure, attached to different, non-planar surfaces of the aircraft; and
FIGS. 11 and 12 are perspective views of exemplary embodiments of land vehicles having solar assemblies, according to the present disclosure, attached to surfaces of the land vehicles.

### DESCRIPTION OF ILLUSTRATIVE EMBODIMENTS

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

FIG. 1 - FIG. 7 describe an example of an assembly process according to the present disclosure.

FIG. 1 is a perspective view of a fixture 100 for assembling the airfoil according to an example of the present disclosure. The operative surface 110 of the fixture is generally concave and in the "negative" shape of the convex solar cell assembly to be formed, which in one embodiment is a portion of an airfoil.

FIG. 2 is an enlarged cross-sectional view of the surface of the fixture of FIG. 1 after placement of an ethylene tetrafluoroethylene (EFTE) film 102 on the surface 110 of the fixture.

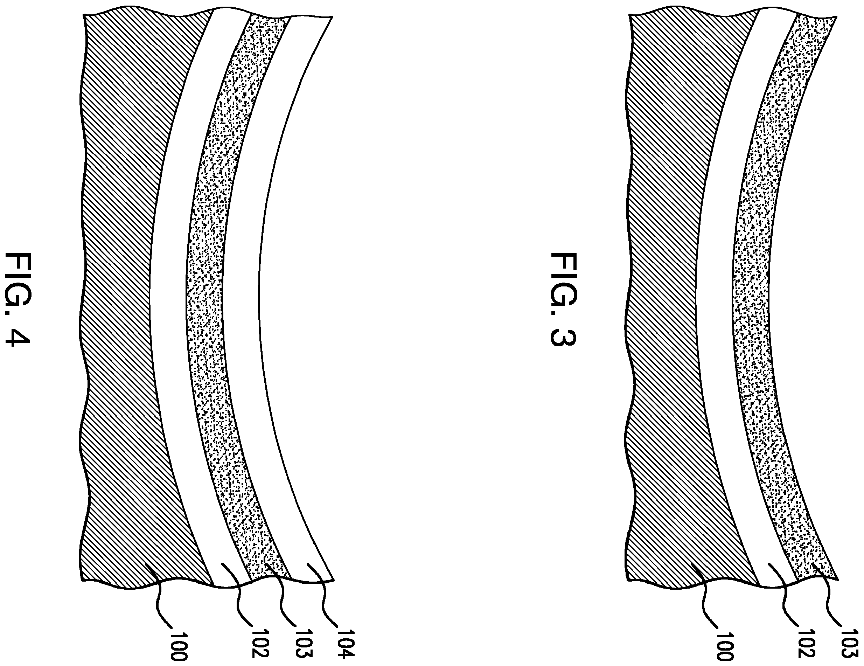

FIG. 3 is a cross-sectional view of the assembly of FIG. 2 after the next process step of mounting a film 103 composed of a pressure sensitive adhesive directly over the ETFE film 102. In an example, the pressure sensitive adhesive may be a non cross-linked silicone adhesive.

In some embodiments, the pressure sensitive adhesive film is between 0.001 and 0.010 inches (0.0254 mm - 0.254 mm) in thickness.

In some embodiments, the array of solar cells is between 0.010 and 0.030 inches (0.254 mm - 0.762 mm) in thickness.

FIG. 4 is a cross-sectional view of the assembly of FIG. 3 after the next process step of mounting an array of interconnected solar cells 104 directly over the adhesive film 103. In this example, the solar cells are placed "facing down", i.e. the surface of the solar cell that in use is to be irradiated by the sun is facing downwards. In this example, the top layer of the resulting assembly will be formed by the ETFE layer as will be explained herein.

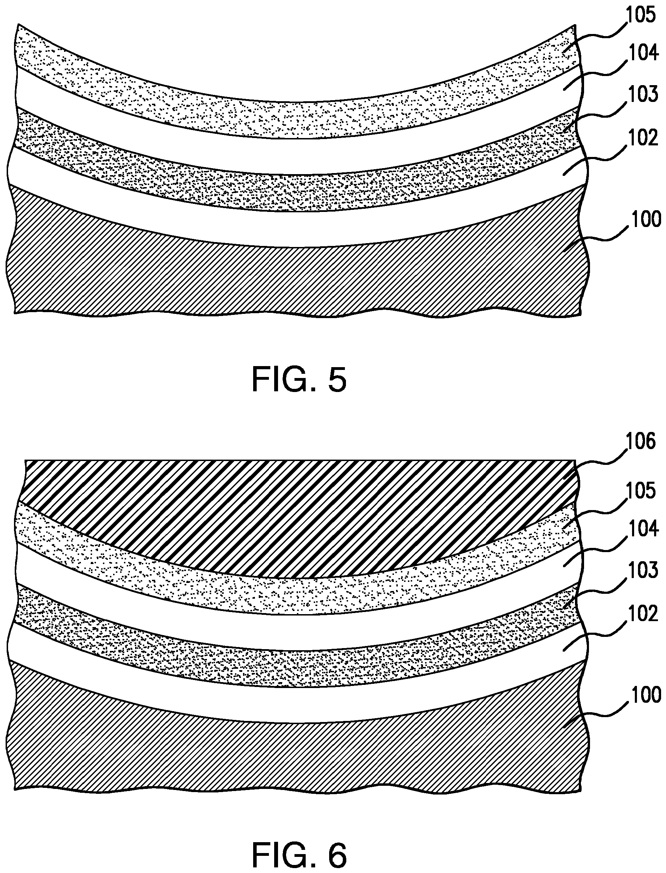

FIG. 5 is a cross-sectional view of the assembly of FIG. 4 after the next process step of mounting an uncured supporting film 105 composed of a composite material directly on the pressure sensitive adhesive film 103, and co-curing the film 105 of composite material so that the array of interconnected solar cells is bonded to the supporting film. The supporting film is thus placed on the backside of the solar cells, i.e. the side of the solar cells that in use is not configured to be irradiated by the sun.

FIG. 6 is a cross-sectional view of the assembly of FIG. 5 after the next process step in which a support structure 106 is bonded to the supporting film 105. In one embodiment, the supporting structure is an airfoil.

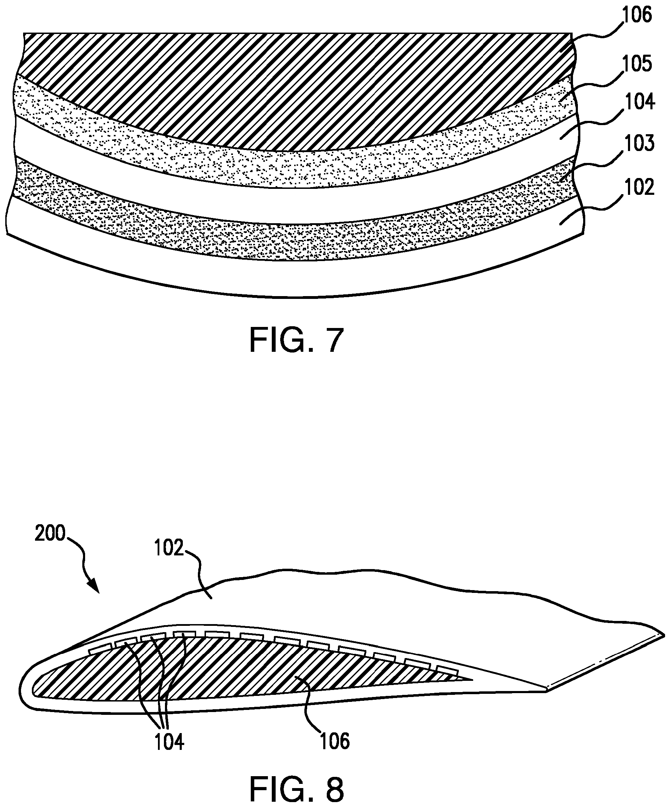

FIG. 7 is a cross-sectional view of a solar cell assembly or airfoil structure 106 as fabricated in FIG. 6 after removal from the fixture 100. The combination of the adhesive and the co-curing of the supportive film provide for an effective and relatively simple assembly procedure. The ETFE film provides for easy release from the fixture and a resulting smooth outer surface. The resulting airfoil may have a good aerodynamic performance in spite of the solar cells thanks to the smooth outer surface.

FIG. 8 is a perspective view of an airfoil 200 with individual solar cells 104 mounted on the top surface thereof, with the top surface being formed by the EFTE film 102.

In addition to an airfoil, the present technique may be used to fabricate solar cells on a wide variety of surfaces, apparatus and objects, in particular the non-planar surface of a variety of different vehicles or other structures (e.g., building materials).

Exemplary aircraft having non-planar surfaces include aerostats (which are lighter than air), and aerodynes (which are heavier than air). Exemplary aerostats can include, for example, unpowered vessels (e.g., balloons such as hot air balloons, helium balloons, and hydrogen balloons) and powered vessels (e.g., airships or dirigibles). Exemplary aerodynes can include, for example, unpowered vessels (e.g., kites and gliders) and powered vessels (e.g., airplanes and helicopters). Exemplary aerodynes can be fixed wing vessels (e.g., airplanes and gliders) or rotorcraft (e.g., helicopters and autogyros).

Exemplary watercraft having non-planar surfaces can be motorized or non-motorized, and can be propelled or tethered. Exemplary watercraft can include surface vessels (e.g., ships, boats, and hovercraft) and submersible vessels (e.g., submarines and underwater flotation vessels).

Exemplary land vehicles having non-planar surfaces can be motorized (e.g., automobiles, trucks, buses, motorcycles, rovers, and trains) or non-motorized (e.g., bicycles). In all such applications, aerodynamic performance may be important and may be improved by the assembly procedures disclosed herein resulting in a smooth outer surface.

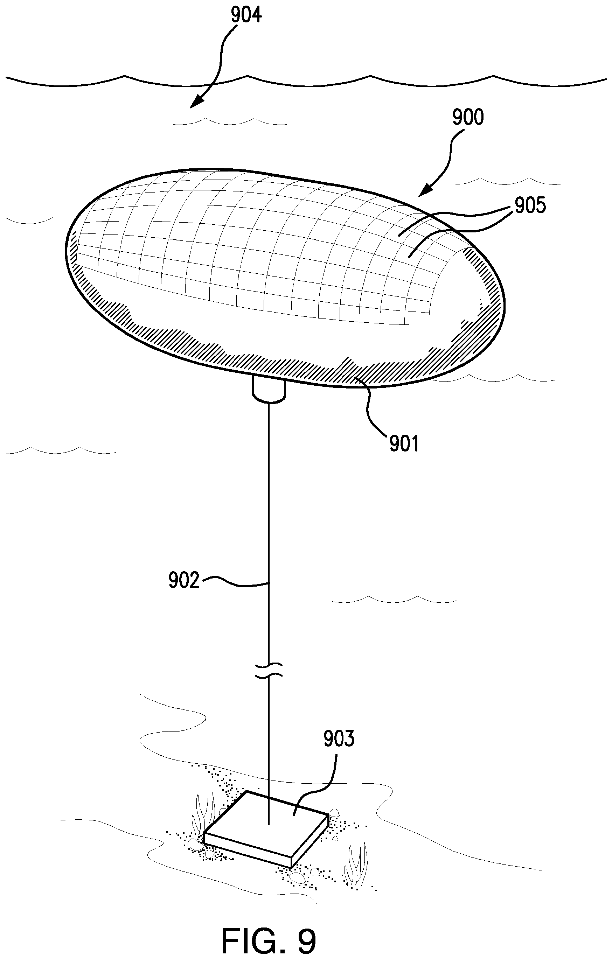

FIG. 9 is a perspective view of an exemplary embodiment of a watercraft. A submersible watercraft 904 has a non-planar surface and is attached to platform 903 via tether 902. Submersible watercraft 904 includes the underwater flotation vessel 901 that is held at a desired depth below the water surface by controlling the length of the tether 902. The solar cell assembly 900 is attached to a non-planar surface of the underwater flotation vessel 901. In certain embodiments, when light impinges on the solar cell assembly 900 of submersible watercraft 904, electrical current generated from the solar cell assembly 900 can be provided to platform 903 via the tether 902.

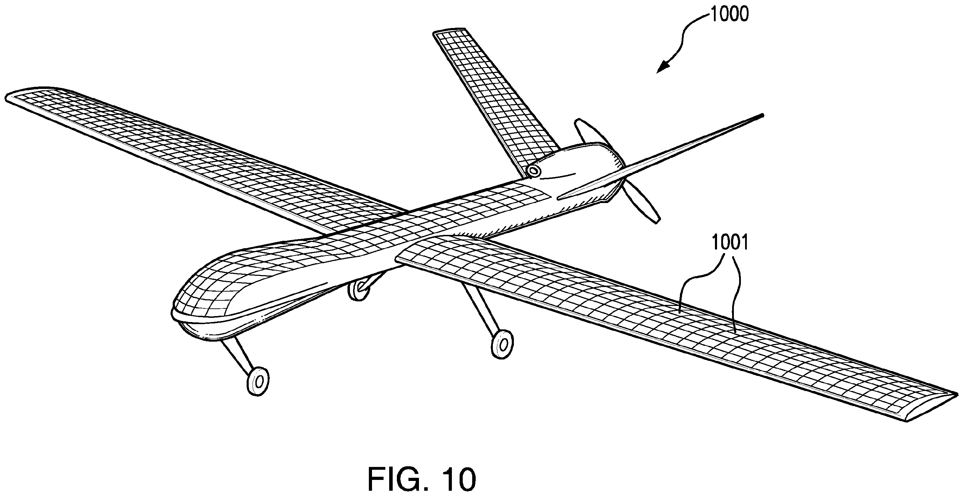

FIG. 10 is a perspective view of an exemplary embodiment of an unmanned aircraft. Aircraft 1000 has a plurality of non-planar surfaces and is a fixed wing vessel. The solar cell assembly 1001 may be attached to a non-planar surface of the wing of the aircraft 1000 and/or to a fuselage surface and/or tail wing surface. In certain embodiments, when light impinges on the solar cell assembly 1001 of aircraft 1000, electrical current generated from the solar cell assembly 1001 can be provided for operation of systems (e.g., navigational systems, propulsion systems, and the like) of aircraft 1000.

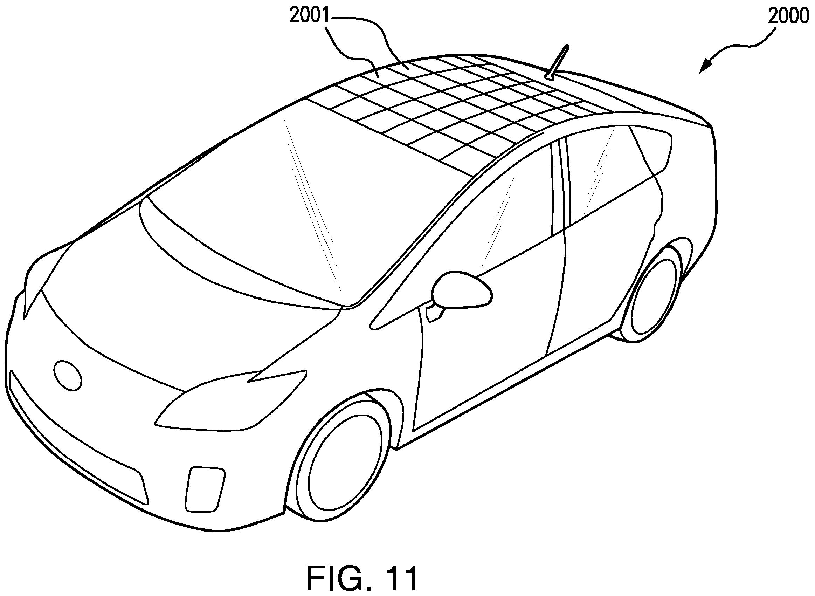

FIG. 11 is a perspective view of an exemplary embodiment of a land vehicle. Land vehicle 2000 has a non-planar roof surface and is an automobile. The solar cell assembly 2001 is attached to a non-planar surface of an automobile 2000. In certain embodiments, when light impinges on the solar cell assembly 2001 of automobile 2000, electrical current generated from solar cell assembly 2001 can be provided for operation systems (e.g., navigational systems, propulsion systems, and the like) of automobile 2000. In certain embodiments, automobile 2000 is a hybrid or electric powered automobile.

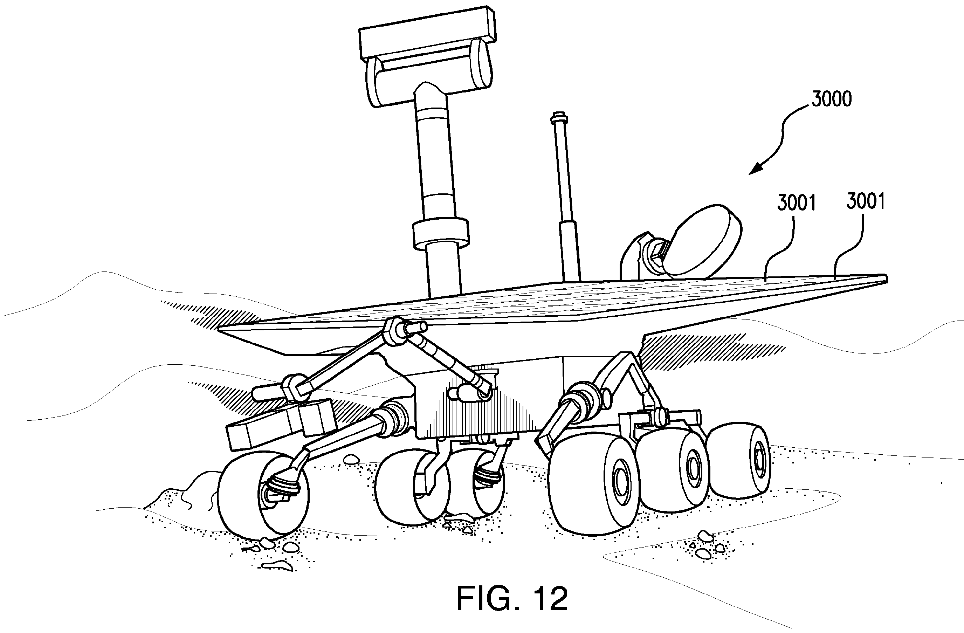

FIG. 12 is a perspective view of another exemplary embodiment of a land vehicle. Land vehicle 3000 may have a planar or a non-planar surface and is a rover that can be used for land navigation and/or exploration on earth or other planets. The solar cell assembly 3001 is attached to a surface of the rover 3000. In certain embodiments, when light impinges on the solar cell assembly 3001 of rover 3000, electrical current generated from solar cell assembly 3001 can be provided for operation of systems (e.g., navigational systems, propulsion systems, and the like) of rover 3000. In certain embodiments, rover 3000 is a hybrid or electric powered land vehicle.

Although some specific embodiments of the present disclosure have been demonstrated in detail with examples, it should be understood by a person skilled in the art that the above examples are only intended to be illustrative but not to limit the scope of the present disclosure. It should be understood that the above embodiments can be modified without departing from the scope of the present disclosure which are to be defined by the attached claims.

## Claims

1. A method of fabricating a solar cell array **characterized by** comprising:
providing a composite face sheet on an assembly fixture, the assembly fixture having a convex surface;
providing a double sided adhesive film and positioning it on the top surface of the face sheet;
bonding a bottom surface of the adhesive film to the top surface of the face sheet by co-curing;
positioning an array of solar cells (104) over the top surface of the adhesive film, the solar cells having a front side configured to be irradiated by light and a back side;
bonding each cell of the array of solar cells (104) to a predefined region on the top surface of the face sheet;
covering the front side of the solar cells with a film composed of ethyleny tetrafluoro ethylene (ETFE), wherein an adhesive film is arranged between the solar cells and the ETFE film.

2. The method according to claim 1, further comprising removing the assembly of the solar cells and the composite face sheet from the assembly fixture.

3. The method according to claim 1 or 2, wherein the assembly fixture (100) has a portion corresponding to a shape of an airfoil.

4. The method according to any of claims 1 - 3, wherein the assembly fixture (100) has a surface roughness of less than 0.001 inches (25.4 microns) rms.

5. The method according to any of claims 1 - 4, further comprising bonding a foam supporting structure to the composite face sheet.

6. The method according to any of claims 1 - 5, wherein one or more of the adhesive films is provided with a release liner, optionally two release liners, and the method comprising removing the release liners.

7. The method according to any of claims 1 - 6, wherein one or more adhesive films are continuous films.

8. The method according to any of claims 1 - 7, wherein one or more of the adhesive films are patterned films.

9. The method according to any of claims 1 - 8, wherein the solar cells include electrically connected III-V compound semiconductor multijunction solar cells.

10. The method according to any of claims 1 - 9, wherein the composite face sheet includes a poly (4, 4'-oxydiphenylene-pyromellitimide) material.

11. The method according to any of claims 1 - 10, wherein the composite face sheet is a carbon fiber composite face sheet.

## Patentansprüche

1. Verfahren zur Herstellung einer Solarzellenanordnung, **dadurch gekennzeichnet, dass** es umfasst:
Bereitstellen eines Kompositdeckschichts auf einer Montagevorrichtung, wobei die Montagevorrichtung eine konvexe Oberfläche aufweist;
Bereitstellung einer doppelseitigen Klebefolie und Anbringung auf der Oberseite des Deckblatts;
Verkleben der Unterseite der Klebefolie mit der Oberseite der Deckschicht durch gemeinsames Aushärten;
Anbringen eines Arrays von Solarzellen (104) über der oberen Oberfläche des Klebefilms, wobei die Solarzellen eine Vorderseite, die so konfiguriert ist, dass sie von Licht bestrahlt wird, und eine Rückseite haben;
Verbinden jeder Zelle der Solarzellenanordnung (104) mit einem vordefinierten Bereich auf der Oberseite der Deckschicht;
Bedecken der Vorderseite der Solarzellen mit einer Folie aus Ethylen-Tetrafluorethylen (ETFE), wobei zwischen den Solarzellen und der ETFE-Folie eine Klebefolie angeordnet ist.

2. das Verfahren nach Anspruch 1, das ferner das Entfernen der Baugruppe aus den Solarzellen und der Verbunddeckschicht aus der Montagevorrichtung umfasst.

3. Das Verfahren nach Anspruch 1 oder 2, wobei die Montagevorrichtung (100) einen Abschnitt aufweist, der der Form eines Tragflügels entspricht.

4. Verfahren nach einem der Ansprüche 1 bis 3, wobei die Montagevorrichtung (100) eine Oberflächenrauhigkeit von weniger als 0,001 Zoll (25,4 Mikrometer) rms aufweist.

5. Verfahren nach einem der Ansprüche 1 bis 4, das ferner das Verbinden einer Schaumstoffstützstruktur mit der Verbunddeckschicht umfasst.

6. Verfahren nach einem der Ansprüche 1 bis 5, wobei eine oder mehrere der Klebefolien mit einer Trennfolie, gegebenenfalls zwei Trennfolien, versehen sind und das Verfahren das Entfernen der Trennfolien umfasst.

7. Verfahren nach einem der Ansprüche 1 bis 6, wobei eine oder mehrere Klebefolien Endlosfolien sind.

8. Verfahren nach einem der Ansprüche 1 bis 7, wobei eine oder mehrere der Klebefolien gemusterte Folien sind.

9. Verfahren nach einem der Ansprüche 1 bis 8, wobei die Solarzellen elektrisch verbundene III-V-Verbindungshalbleiter-Mehrfachsolarzellen umfassen.

10. Verfahren nach einem der Ansprüche 1 bis 9, wobei die Kompositdeckschicht ein Poly(4,4'-oxydiphenylen-pyromellitimid)-Material enthält.

11. Verfahren nach einem der Ansprüche 1 bis 10, wobei die Kompositdeckschicht eine Kohlenstofffaser Kompositdeckschicht ist.

## Revendications

1. Procédé de fabrication d'un assemblage de cellules solaires, **caractérisé en ce qu'**il comprend :
Fournir une feuille de couverture composite sur un dispositif de montage, dans lequel le dispositif de montage a une surface convexe ;
Fournir un film adhésive double face et le fixer au sommet de la feuille de couverture ;
Coller la face inférieure du film adhésif à la face supérieure de la feuille de couverture en les faisant durcir ensemble ;
Montage d'un réseau de cellules solaires (104) sur la surface supérieure du film adhésif, les cellules solaires ayant une surface avant configurée pour être irradiée par la lumière et une surface arrière ;
Connecter chaque cellule du réseau de cellules solaires (104) à une zone prédéfinie sur le dessus de la couche de couverture ;
Recouvrir la face avant des cellules solaires d'un film d'éthylène tétrafluoroéthylène (ETFE), dans lequel un film adhésif est disposé entre les cellules solaires et le film ETFE.

2. Procédé de la revendication 1, comprenant en outre le retrait de l'ensemble des cellules solaires et de la couche supérieure composite du dispositif de montage.

3. Procédé selon la revendication 1 ou 2, dans lequel le dispositif de montage (100) comprend une partie correspondant à la forme d'un profilé aérodynamique.

4. Procédé selon l'une quelconque des revendications 1 à 3, dans lequel le dispositif de montage (100) a une rugosité de surface inférieure à 0,001 pouce (25,4 microns) rms.

5. Procédé selon l'une quelconque des revendications 1 à 4, comprenant en outre la liaison d'une structure de support en mousse à la feuille de couverture composite.

6. Procédé selon l'une quelconque des revendications 1 à 5, dans lequel un ou plusieurs des films adhésifs sont pourvus d'un film de séparation, éventuellement de deux films de séparation, et le procédé comprend le retrait des films de séparation.

7. Procédé de l'une quelconque des revendications 1 à 6, dans lequel un ou plusieurs films adhésifs sont des films continus.

8. Procédé de l'une quelconque des revendications 1 à 7, dans lequel un ou plusieurs des films adhésifs sont des films à motifs.

9. Procédé de l'une quelconque des revendications 1 à 8, dans lequel les cellules solaires comprennent des cellules solaires multi-jonction à semi-conducteurs composés III-V connectées électriquement.

10. Procédé de l'une quelconque des revendications 1 à 9, dans lequel la feuille de couverture composite comprend un matériau de poly(4,4'-oxydiphénylènepyromellitimide).

11. Procédé de l'une quelconque des revendications 1 à 10, dans lequel la feuille de couverture composite est une feuille de couverture composite en fibre de carbone.
